(19) Europäisches Patentamt
European Patent Office
Office européen des brevets

(11) EP 4 679 948 A1

(12) EUROPEAN PATENT APPLICATION
published in accordance with Art. 153(4) EPC

(43) Date of publication:
14.01.2026 Bulletin 2026/03

(51) International Patent Classification (IPC):
H05K 3/32 (2026.01)

(21) Application number: 23926345.2

(52) Cooperative Patent Classification (CPC):
H05K 3/32

(22) Date of filing: 09.03.2023

(86) International application number:
PCT/JP2023/009100

(87) International publication number:
WO 2024/185135 (12.09.2024 Gazette 2024/37)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Fuji Corporation
Chiryu-shi, Aichi 472-8686 (JP)

(72) Inventor: SAKAKIBARA, Ryo
Chiryu-shi, Aichi 472-8686 (JP)

(74) Representative: Grünecker Patent- und
Rechtsanwälte
PartG mbB
Leopoldstraße 4
80802 München (DE)

(54) **ELECTRICAL CIRCUIT FORMING METHOD AND ELECTRICAL CIRCUIT FORMING DEVICE**

(57) An electrical circuit forming method according to the present disclosure includes: a wiring forming step of forming a metal wiring line on a resin layer; a first application step of applying a conductive fluid to a planned mounting position of an electrode of an electronic component on the metal wiring line; a first curing step of curing the conductive fluid applied in the first application step; a second application step of applying a conductive fluid onto the conductive fluid cured in the first curing step; a mounting step of mounting the electronic component such that the electrode comes into contact with the conductive fluid applied in the second application step; and a second curing step of curing the conductive fluid applied in the second application step after the electronic component is mounted in the mounting step.

[Fig. 15]

## Description

Technical Field

The present invention relates to an electrical circuit forming method in which a metal wiring line formed on a resin layer and an electrode of an electronic component are connected by a conductive fluid.

Background Art

The following Patent Document 1 describes a technique of connecting a metal wiring line formed on a resin layer and an electrode of an electronic component by a conductive fluid.

Citation List

Patent Literature

Patent Literature 1:WO 2022/113186

Summary of the Invention

Technical Problem

An object of the present invention is to appropriately ensure electrical conduction between a metal wiring line formed on a resin layer and an electrode of an electronic component when the metal wiring line and the electrode of the electronic component are connected by a conductive fluid.

Solution to Problem

In order to solve the above problem, the present description discloses an electrical circuit forming method including: a wiring forming step of forming a metal wiring line on a resin layer; a first application step of applying a conductive fluid to a planned mounting position of an electrode of an electronic component on the metal wiring line; a first curing step of curing the conductive fluid applied in the first application step; a second application step of applying the conductive fluid onto the conductive fluid cured in the first curing step; a mounting step of mounting the electronic component such that the electrode comes into contact with the conductive fluid applied in the second application step; and a second curing step of curing the conductive fluid applied in the second application step after the electronic component is mounted in the mounting step.

In addition, the present description discloses an electrical circuit forming device including: a wiring forming device configured to form a metal wiring line; an application device configured to apply a conductive fluid; a curing device configured to cure the conductive fluid; a mounting device configured to mount an electronic component; and a control device, in which the control device is configured to execute: a wiring forming process of forming the metal wiring line on a resin layer using the wiring forming device; a first application process of applying the conductive fluid onto a planned mounting position of an electrode of an electronic component on the metal wiring line using the application device; a first curing process of curing the conductive fluid applied in the first application process using the curing device; a second application process of applying a conductive fluid onto the conductive fluid cured in the first curing process using the application device; a mounting process of mounting the electronic component such that the electrode comes into contact with the conductive fluid applied in the second application process using the mounting device; and a second curing process of curing the conductive fluid applied in the second application process using the curing device after the electronic component is mounted in the mounting process.

Advantageous Effects of Invention

In the present disclosure, a conductive fluid is applied to a planned mounting position of an electrode of an electronic component on a metal wiring line, and the conductive fluid is cured. Then, the conductive fluid is applied onto the cured conductive fluid, and after the electronic component is mounted such that the electrode comes into contact with the conductive fluid, the conductive fluid in contact with the electrode is cured. Accordingly, it is possible to appropriately ensure electrical conduction between the metal wiring line and the electrode of the electronic component.

Brief Description of Drawings

Fig. 1 is a diagram illustrating an example of a circuit forming device.
Fig. 2 is a block diagram illustrating an example of a control device.
Fig. 3 is a cross-sectional view illustrating an example of a circuit board in a state in which a resin laminate is formed.
Fig. 4 is a cross-sectional view illustrating an example of the circuit board in a state in which a wiring line is formed on the resin laminate.
Fig. 5 is a cross-sectional view illustrating an example of the circuit board in a state in which another resin laminate is further formed on the resin laminate.
Fig. 6 is a cross-sectional view illustrating an example of the circuit board in a state in which conductive paste is applied onto the wiring line.
Fig. 7 is a cross-sectional view illustrating an example of the circuit board in a state in which a thermosetting resin is applied onto a resin layer.
Fig. 8 is a cross-sectional view illustrating an example of the circuit board in a state in which an electronic component is mounted.

Fig. 9 is a cross-sectional view illustrating an example of the circuit board in a state in which the electronic component is pressed toward the resin laminate.

Fig. 10 is a cross-sectional view illustrating an example of the circuit board in a state in which the thermosetting resin is applied around the electronic component.

Fig. 11 is a cross-sectional view illustrating an example of the circuit board in which the wiring line and an electrode of the electronic component are connected by a thin bump.

Fig. 12 is a cross-sectional view illustrating an example of the circuit board in which a conductive fluid is ejected onto a cured conductive fluid.

Fig. 13 is a view illustrating an example of the circuit board when a first-stage conductive fluid is ejected.

Fig. 14 is a view illustrating an example of the circuit board when a second-stage conductive fluid is ejected.

Fig. 15 is a cross-sectional view illustrating the circuit board in a state in which the thermosetting resin is applied onto the resin layer.

Fig. 16 is a cross-sectional view illustrating the circuit board in a state in which the electronic component is mounted.

Fig. 17 is a cross-sectional view illustrating the circuit board in a state in which the electronic component is pressed toward the resin laminate.

Fig. 18 is a cross-sectional view illustrating the circuit board in a state in which the thermosetting resin is applied around the electronic component.

Description of Embodiments

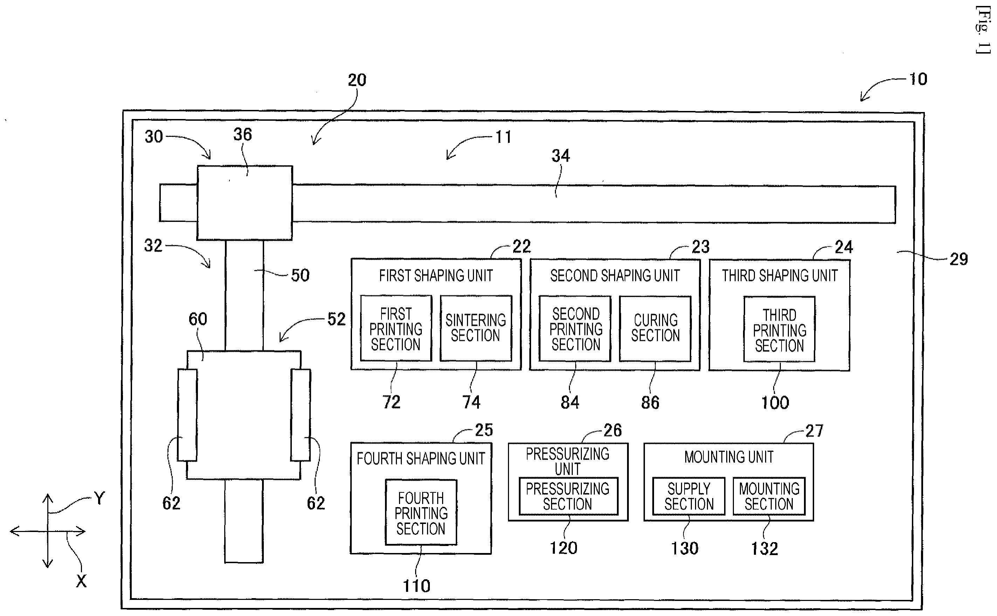

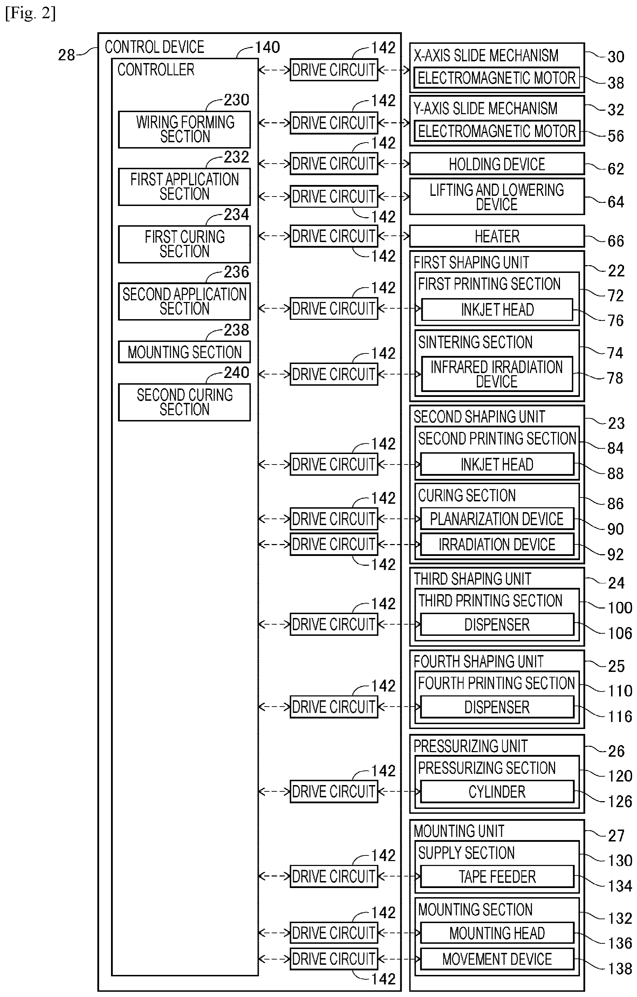

Fig. 1 illustrates an example of circuit forming device 10. Circuit forming device 10 includes conveyance device 20, first shaping unit 22, second shaping unit 23, third shaping unit 24, fourth shaping unit 25, pressurizing unit 26, mounting unit 27, and control device (refer to Fig. 2) 28. Conveyance device 20, first shaping unit 22, second shaping unit 23, third shaping unit 24, fourth shaping unit 25, pressurizing unit 26, and mounting unit 27 are disposed on base 29 of circuit forming device 10. Base 29 is generally rectangular in shape, and in the following description, a longitudinal direction of base 29 will be referred to as an X-axis direction, a transverse direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Further, X-axis slide mechanism 30 includes electromagnetic motor (refer to Fig. 2) 38, and X-axis slider 36 moves to any position in the X-axis direction by the drive of electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end portion of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor (refer to Fig. 2) 56, and stage 52 moves to any position in the Y-axis direction by the drive of electromagnetic motor 56. As a result, stage 52 moves to any position on base 29 by the drive of X-axis slide mechanism 30 and Y-axis slide mechanism 32.

Stage 52 includes base plate 60, holding device 62, lifting and lowering device (refer to Fig. 2) 64, and heater (refer to Fig. 2) 66. Base plate 60 is formed in a flat plate shape, and a board is placed on an upper surface thereof. Holding device 62 is provided on both side portions of base plate 60 in the X-axis direction. Both edge portions of the board placed on base plate 60 in the X-axis direction are sandwiched by holding device 62, thereby fixedly holding the board. In addition, lifting and lowering device 64 is disposed below base plate 60 to lift and lower base plate 60. Further, heater 66 is incorporated into base plate 60 and heats the board placed on base plate 60 to any temperature.

First shaping unit 22 is a unit that shapes a wiring line of a circuit board, and includes first printing section 72 and sintering section 74. First printing section 72 includes inkjet head (refer to Fig. 2) 76, and inkjet head 76 linearly ejects metal ink. The metal ink is a metal ink in which nanometer-sized metal fine particles, for example, silver fine particles, are dispersed in a solvent. Surfaces of the metal fine particles are coated with a dispersant to prevent aggregation in the solvent. Additionally, inkjet head 76 ejects the metal ink from multiple nozzles by, for example, a piezoelectric method using a piezoelectric element.

Sintering section 74 includes infrared irradiation device (refer to Fig. 2) 78. Infrared irradiation device 78 is a device that irradiates the ejected metal ink with infrared rays. The metal ink irradiated with the infrared rays is subjected to sintering, thereby forming the wiring line. Sintering of the metal ink is a phenomenon in which applying energy causes the solvent to evaporate, the protective films of the metal fine particles, that is, the dispersant, to break down, or the like, so that the metal fine particles come into contact with or fuse each other, thereby increasing the conductivity. The metal ink is sintered to form a metal wiring line.

In addition, second shaping unit 23 is a unit that shapes a resin layer of the circuit board, and includes second printing section 84 and curing section 86. Second printing section 84 includes inkjet head (refer to Fig. 2) 88, and inkjet head 88 ejects an ultraviolet curable resin. The ultraviolet curable resin is a resin to be cured by irradiation with ultraviolet rays. Inkjet head 88 may employ, for example, a piezoelectric method using a piezoelectric element, or may be a thermal method in which a resin is heated to generate bubbles which are ejected from multiple nozzles.

Curing section 86 includes planarization device (refer to Fig. 2) 90 and irradiation device (refer to Fig. 2) 92. Planarization device 90 planarizes an upper surface of the ultraviolet curable resin ejected by inkjet head 88, and makes a thickness of the ultraviolet curable resin uniform by, for example, evening out the surface of the ultraviolet curable resin while scraping off an excess resin with a roller or a blade. Additionally, irradiation device 92 includes a mercury lamp or an LED as a light source and irradiates the ejected ultraviolet curable resin with ultraviolet rays. As a result, the ejected ultraviolet curable resin is cured to form a resin layer.

Third shaping unit 24 is a unit that shapes a connection section between an electrode of an electronic component and the wiring line on the circuit board, and includes third printing section 100. Third printing section 100 includes dispenser (refer to Fig. 2) 106, and dispenser 106 ejects conductive paste. The conductive paste is conductive paste in which micrometer-sized metal particles are dispersed in a resin to be cured by relatively low-temperature heating. Incidentally, the metal particles have a flake shape, and viscosity of the conductive paste is relatively higher compared to that of the metal ink. Dispenser 106 can change the ejection amount per unit time by adjusting the pressure during ejection. Alternatively, dispenser 106 can also change the ejection amount by changing the ejection time in a state in which the ejection amount per unit time is constant.

The conductive paste ejected by dispenser 106 is heated by heater 66 incorporated into base plate 60. In the heated conductive paste, the resin is cured. At this time, in the conductive paste, the resin is cured and contracted, and the flake-shaped metal particles dispersed in the resin come into contact with each other. Consequently, the conductive paste exhibits conductivity. In addition, the resin of the conductive paste is an organic adhesive, and exhibits an adhesive force when cured by heating. The conductive paste is cured at, for example, about 80°C.

Fourth shaping unit 25 is a unit that shapes a resin for fixing the electronic component to the circuit board, and includes fourth printing section 110. Fourth printing section 110 includes dispenser (refer to Fig. 2) 116, and dispenser 116 ejects a thermosetting resin. The thermosetting resin is a resin to be cured by heating. Dispenser 116 employs, for example, an air pulse method using compressed air. The thermosetting resin ejected from dispenser 116 is heated by heater 66 incorporated into base plate 60 and is cured. The thermosetting resin is cured at, for example, about 80°C.

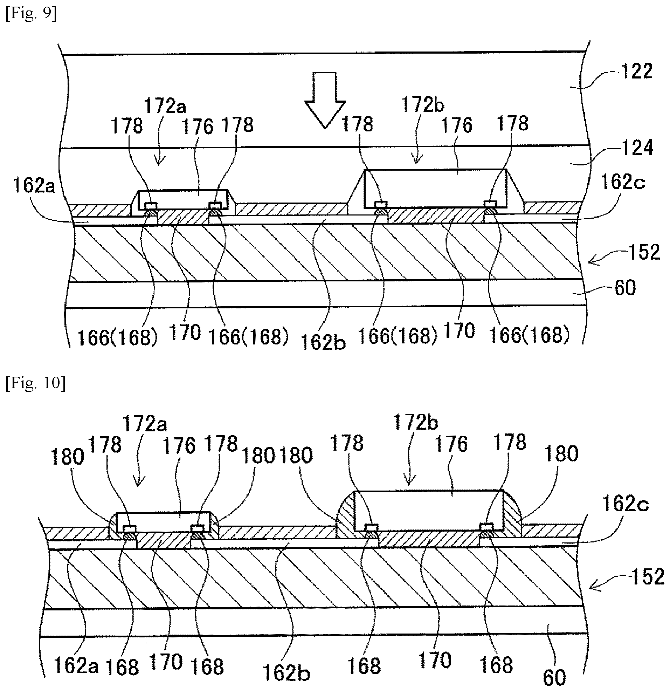

In addition, pressurizing unit 26 is a unit for pressurizing the circuit board, and includes pressurizing section 120. Pressurizing section 120 includes pressurizing plate (refer to Fig. 9) 122, rubber plate (refer to Fig. 9) 124, and cylinder (refer to Fig. 2) 126. Rubber plate 124 is formed of, for example, silicone rubber and has a plate shape. Further, pressurizing plate 122 is formed of, for example, steel material and has a plate shape. Rubber plate 124 is bonded to a lower surface of pressurizing plate 122, and pressurizing plate 122 is pressed toward the circuit board by the operation of cylinder 126. Consequently, the circuit board is pressurized by pressurizing plate 122 via rubber plate 124. By controlling the operation of cylinder 126, it is possible to controllably change the pressurizing force applied to the board.

Additionally, mounting unit 27 is a unit that mounts the electronic component on the circuit board, and includes supply section 130 and mounting section 132. Supply section 130 includes multiple tape feeders (refer to Fig. 2) 134 that feed taped electronic components one by one, and supplies the electronic component at a supply position. Supply section 130 is not limited to tape feeder 134 and may be a tray type supply device that supplies the electronic component by picking up the electronic component from a tray. Alternatively, supply section 130 may include both the tape type supply device and the tray type supply device, or other supply devices.

Mounting section 132 includes mounting head (refer to Fig. 2) 136 and movement device (refer to Fig. 2) 138. Mounting head 136 includes a suction nozzle (not illustrated) for picking up and holding the electronic component. The suction nozzle picks up and holds the electronic component by suctioning air through the supply of a negative pressure from a positive and negative pressure supply device (not illustrated). By supplying a slight positive pressure from the positive and negative pressure supply device, the electronic component is released. Additionally, movement device 138 moves mounting head 136 between the supply position of the electronic component by tape feeder 134 and the board placed on base plate 60. Consequently, in mounting section 132, the electronic component supplied from tape feeder 134 is held by the suction nozzle, and the electronic component held by the suction nozzle is mounted on the board.

In addition, control device 28 includes controller 140 and multiple drive circuits 142, as illustrated in Fig. 2. Multiple drive circuits 142 are connected to electromagnetic motors 38 and 56, holding device 62, lifting and lowering device 64, heater 66, inkjet head 76, infrared irradiation device 78, inkjet head 88, planarization device 90, irradiation device 92, dispenser 106, dispenser 116, cylinder 126, tape feeder 134, mounting head 136, and movement device 138 described above. Controller 140 includes CPU, ROM, RAM, and the like, is mainly configured as a computer, and is connected to multiple drive circuits 142. As a result, the operations of conveyance device 20, first shaping unit 22, second shaping unit 23, third shaping unit 24, fourth shaping unit 25, pressurizing unit 26, and mounting unit 27 are controlled by controller 140.

With the configuration described above, in circuit forming device 10, a resin laminate is formed on base plate 60, and a wiring line is formed on an upper surface of the resin laminate. The electrode of the electronic component is electrically connected to the wiring line via the conductive paste, and the electronic component is fixed by the resin, thereby forming the circuit board.

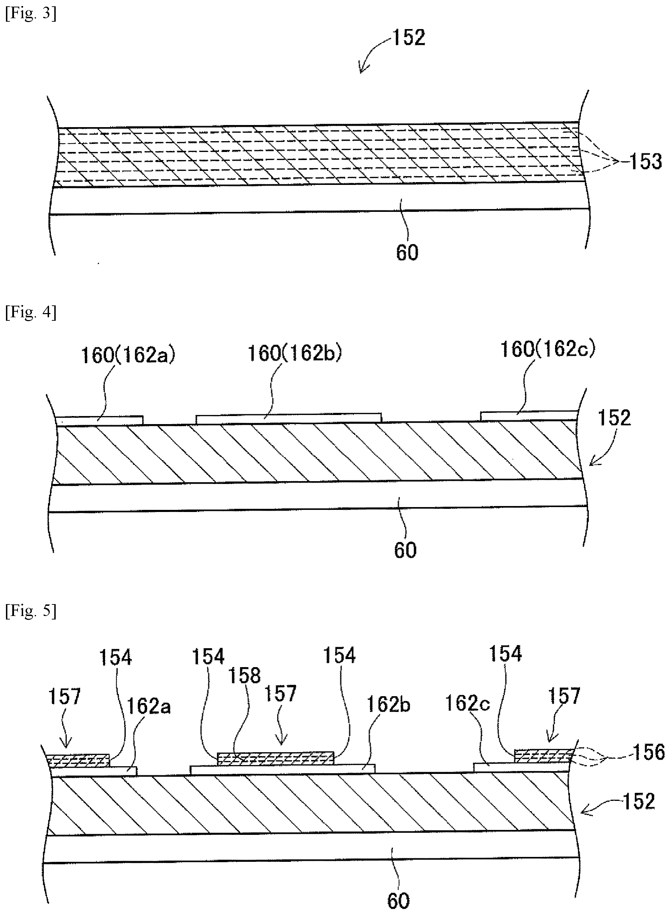

An example of a process of forming a circuit board will be described. Specifically, first, stage 52 is moved below second shaping unit 23. Then, in second shaping unit 23, as illustrated in Fig. 3, resin laminate 152 is formed on base plate 60 of stage 52. Resin laminate 152 is formed by repeatedly ejecting the ultraviolet curable resin from inkjet head 88 and irradiating the ejected ultraviolet curable resin with ultraviolet rays from irradiation device 92.

In detail, in second printing section 84 of second shaping unit 23, inkjet head 88 ejects the ultraviolet curable resin in a thin film shape onto the upper surface of base plate 60. Subsequently, when the ultraviolet curable resin is ejected in a thin film shape, in curing section 86, the ultraviolet curable resin is planarized by planarization device 90 such that the ultraviolet curable resin has a uniform film thickness. Then, irradiation device 92 irradiates the thin film-shaped ultraviolet curable resin with ultraviolet rays. As a result, thin film-shaped resin layer 153 is formed on base plate 60.

Subsequently, inkjet head 88 ejects the ultraviolet curable resin in a thin film shape onto thin film-shaped resin layer 153. The thin film-shaped ultraviolet curable resin is planarized by planarization device 90, irradiation device 92 irradiates the ultraviolet curable resin ejected in a thin film shape with ultraviolet rays, thereby laminating thin film-shaped resin layer 153 on thin film-shaped resin layer 153. In this manner, by repeatedly ejecting the ultraviolet curable resin onto thin film-shaped resin layer 153 and irradiating the ultraviolet curable resin with ultraviolet rays and by laminating multiple resin layers 153, resin laminate 152 is formed.

Next, when resin laminate 152 is formed, stage 52 is moved below first shaping unit 22. Then, in first printing section 72 of first shaping unit 22, as illustrated in Fig. 4, inkjet head 76 linearly ejects metal ink 160 on an upper surface of resin laminate 152 in accordance with a circuit pattern. Subsequently, infrared irradiation device 78 irradiates metal ink 160 ejected in accordance with the circuit pattern with infrared rays in sintering section 74 of first shaping unit 22. Consequently, metal ink 160 is subjected to sintering, thereby forming wiring line 162 on the upper surface of resin laminate 152. In Fig. 4, three wiring lines 162 are formed, but in a case where three wiring lines 162 are distinguished from each other, the wiring line on the left side in Fig. 4 will be described as wiring line 162a, the wiring line at the center will be described as wiring line 162b, and the wiring line on the right side will be described as wiring line 162c.

Subsequently, when wiring line 162 is formed on resin laminate 152, stage 52 is moved below second shaping unit 23. Then, in second shaping unit 23, inkjet head 88 ejects the ultraviolet curable resin in a thin film shape such that end portions of three wiring lines 162 are exposed. Subsequently, when the ultraviolet curable resin is ejected in a thin film shape, in curing section 86, the ultraviolet curable resin is planarized such that the ultraviolet curable resin has a uniform film thickness. Then, irradiation device 92 irradiates the thin film-shaped ultraviolet curable resin with ultraviolet rays. As a result, as illustrated in Fig. 5, resin layer 156 is formed on resin laminate 152.

Subsequently, inkjet head 88 ejects the ultraviolet curable resin in a thin film shape only onto a portion on resin layer 156. That is, inkjet head 88 ejects the ultraviolet curable resin in a thin film shape onto resin layer 156 such that the end portions of three wiring lines 162 are exposed. The thin film-shaped ultraviolet curable resin is planarized by planarization device 90, and irradiation device 92 irradiates the ultraviolet curable resin ejected in a thin film shape with ultraviolet rays, thereby laminating resin layer 156 on resin layer 156. In this manner, by repeatedly ejecting the ultraviolet curable resin onto resin layer 156 and irradiating the ultraviolet curable resin with ultraviolet rays and by laminating multiple resin layers 156, resin laminate 157 is formed. As a result, resin laminate 157 is formed on resin laminate 152, and a step portion between resin laminate 152 and resin laminate 157 functions as cavity 154.

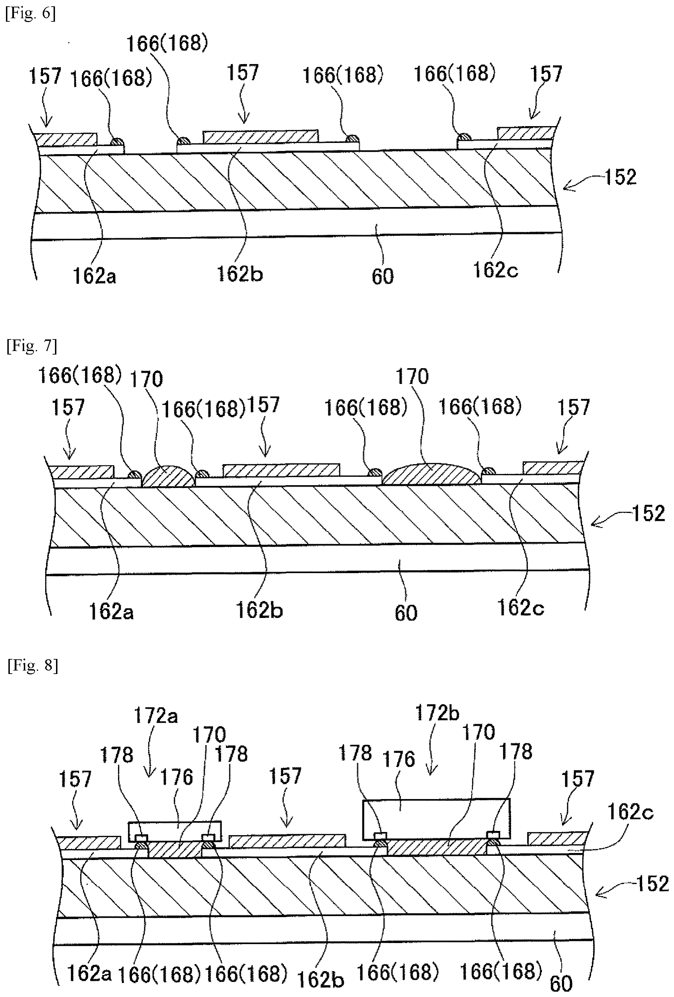

When resin laminate 157 is formed on resin laminate 152 in this manner, stage 52 is moved below third shaping unit 24. In third printing section 100 of third shaping unit 24, as illustrated in Fig. 6, dispenser 106 ejects conductive paste 166 onto both end portions of wiring line 162b, and onto end portions of wiring line 162a and wiring line 162c that face both end portions of wiring line 162b.

As described above, when conductive paste 166 is ejected onto the end portions of wiring line 162, stage 52 is moved below fourth shaping unit 25. In fourth printing section 110 of fourth shaping unit 25, as illustrated in Fig. 7, dispenser 116 ejects thermosetting resin 170 onto the upper surface of resin laminate 152 between the end portions of two wiring lines 162a and 162b that face each other and ejects thermosetting resin 170 onto the upper surface of resin laminate 152 between the end portions of two wiring lines 162b and 162c that face each other.

Then, when thermosetting resin 170 is ejected onto the upper surface of resin laminate 152 between the end portions of two wiring lines 162 that face each other, stage 52 is moved below mounting unit 27. In mounting unit 27, electronic component (refer to Fig. 8) 172 is supplied by tape feeder 134, and electronic component 172 is held by the suction nozzle of mounting head 136. Electronic component 172 includes component body 176 and two electrodes 178 disposed on a lower surface of component body 176. Mounting head 136 is moved by movement device 138, and electronic component 172 held by the suction nozzle is mounted to be electrically connected to wiring line 162 as illustrated in Fig. 8. In Fig. 8, two electronic components 172 are mounted, and two electronic components 172 are different in size. Therefore, a small-sized electronic component will be described as electronic component 172a, and a large-sized electronic component will be described as electronic component 172b. Electronic component 172a is mounted to be electrically connected to two wiring lines 162a and 162b, and electronic component 172b is mounted to be electrically connected to two wiring lines 162b and 162c.

Specifically, electronic component 172a is mounted such that electrode 178 comes into contact with uncured conductive paste 166 ejected onto wiring lines 162a and 162b. At this time, component body 176 of electronic component 172a comes into contact with uncured thermosetting resin 170 ejected between wiring lines 162a and 162b. Additionally, electronic component 172b is mounted such that electrode 178 comes into contact with uncured conductive paste 166 ejected onto wiring lines 162b and 162c. At this time, component body 176 of electronic component 172b comes into contact with uncured thermosetting resin 170 ejected between wiring lines 162b and 162c. That is, conductive paste 166 is ejected to a planned mounting position of electrode 178 on wiring line 162, and thermosetting resin 170 is ejected to a planned mounting position of component body 176. Therefore, by mounting electronic component 172, electrode 178 comes into contact with uncured conductive paste 166 ejected onto wiring line 162, and component body 176 comes into contact with uncured thermosetting resin 170. Further, thermosetting resin 170, which is in contact with component body 176, is enclosed between component body 176 and resin laminate 152. That is, thermosetting resin 170 is enclosed between the upper surface of resin laminate 152 and the lower surface of component body 176. The ejection amount of thermosetting resin 170 by dispenser 116 is controlled such that thermosetting resin 170 does not protrude from between the upper surface of resin laminate 152 and the lower surface of component body 176.

When electronic component 172 is mounted in this manner, stage 52 is moved below pressurizing unit 26. Then, in pressurizing section 120 of pressurizing unit 26, as illustrated in Fig. 9, electronic component 172 mounted on resin laminate 152 is pressed downward from above by pressurizing plate 122 via rubber plate 124. Two electronic components 172a and 172b are mounted on resin laminate 152, and two electronic components 172 are different in size. Therefore, the two electronic components have different height dimensions. However, since rubber plate 124 is bonded to the lower surface of pressurizing plate 122, rubber plate 124 is elastically deformed when two electronic components 172 are pressurized, so that two electronic components 172 having different height dimensions can be properly pressed.

Further, when the electronic component is pressurized in pressurizing unit 26, resin laminate 152 is heated by heater 66 incorporated into base plate 60. As a result, conductive paste 166 and thermosetting resin 170 are heated and cured via resin laminate 152. That is, conductive paste 166 is heated while being compressed between wiring line 162 and electrode 178, and thermosetting resin 170 is heated while being compressed between resin laminate 152 and component body 176, so that conductive paste 166 and thermosetting resin 170 are cured. Here, the heating temperature is a temperature (for example, 80°C) at which conductive paste 166 and thermosetting resin 170 are cured. The heating temperature is a heating temperature for completely curing the conductive paste and the thermosetting resin, and is set by the manufacturer of each of the conductive paste and the thermosetting resin. Further, the heating temperature may be set according to a result of heating each of the conductive paste and the thermosetting resin experimentally performed by a user. In this manner, conductive paste 166 exhibits conductivity by being cured. Additionally, when conductive paste 166 is heated while being compressed, the metal particles contained in conductive paste 166 come into close contact with each other, resulting in increased conductivity. As a result, electronic component 172 is electrically connected to wiring line 162 via cured conductive paste 166. Since cured conductive paste 166 functions as a bump, cured conductive paste 166 is referred to as bump 168. By being pressed by pressurizing plate 122, component body 176 and thermosetting resin 170 come into contact with each other, and electrode 178 and conductive paste 166 come into contact with each other. As a result, due to the adhesive force of thermosetting resin 170, electronic component 172 is fixed to the upper surface of resin laminate 152 in component body 176, and due to the adhesive force of conductive paste 166, electrical connection between electronic component 172 and wiring line 162 is ensured.

When the pressurizing in pressurizing unit 26 is completed, stage 52 is moved below fourth shaping unit 25. Then, in fourth printing section 110 of fourth shaping unit 25, dispenser 116 ejects thermosetting resin 180 around electronic component 172 to cover a side surface of component body 176 of electronic component 172, as illustrated in Fig. 10. Then, resin laminate 152 is heated by heater 66 incorporated into base plate 60. Consequently, thermosetting resin 180 is heated and cured via resin laminate 152. Here, the heating temperature is, for example, a temperature (for example, 80°C) at which thermosetting resin 180 is cured. Consequently, thermosetting resin 180 is cured while covering the side surface of component body 176. That is, in electronic component 172 mounted on resin laminate 152, thermosetting resins 170 and 180 are enclosed between the upper surface of resin laminate 152 and the lower surface of component body 176 and are cured while covering the side surface of component body 176. As a result, electronic component 172 mounted on the upper surface of resin laminate 152 is fixed by the cured resin.

As described above, electronic component 172 is mounted such that electrode 178 comes into contact with uncured conductive paste 166, and electronic component 172 is heated while being pressed by pressurizing plate 122, thereby electrically connecting electronic component 172 and wiring line 162 via bump 168. A bump having a low elastic modulus is adopted as bump 168 that electrically connects electronic component 172 and wiring line 162, thereby ensuring electrical connection between electronic component 172 and wiring line 162. Specifically, the elastic modulus of bump 168, that is, the elastic modulus of conductive paste 166 when being cured is 0.2 GPa or less. Here, elastic modulus E is a physical property value indicating resistance to deformation, and is a general term for a constant of proportionality between a stress $\sigma$ and a strain $\varepsilon$ in elastic deformation. Specifically, elastic modulus E is represented by the following equation, and is also called an elastic coefficient or an elastic constant.

$$E = \sigma/\varepsilon$$

Therefore, as the elastic modulus increases, the object is less likely to be elastically deformed, and as the elastic modulus decreases, the object is more likely to be elastically deformed. The elastic modulus of bump 168 is 0.2 GPa or less as described above. In this case, bump 168 is easily deformed by approximately 7.5 times compared to a bump having a general elastic modulus (for example, approximately 1.5 GPa) using a typical conductive paste. Since bump 168 that is relatively easily deformed connects wiring line 162 and electrode 178 of electronic component 172, the stress generated when the circuit board is deformed is relaxed by bump 168, thereby ensuring electrical conduction between wiring line 162 and electronic component 172.

Specifically, during the formation of the circuit board, heating and cooling are repeatedly performed, and during this process, expansion and contraction of the electronic component may be repeatedly performed. In addition, resin laminate 152 or the like may be warped by heating and cooling during the formation of the circuit board. As described above, when the expansion and contraction of the electronic component are repeatedly performed, bump 168 is deformed in accordance with the stress generated when resin laminate 152 or the like is warped, thereby ensuring electrical conduction between wiring line 162 and electronic component 172. As an experiment demonstrating this, the stress generated between wiring line 162 and electrode 178 when wiring line 162 and electrode 178 were connected by using a general conductive paste instead of conductive paste 166 was measured. On the other hand, the stress generated between wiring line 162 and electrode 178 when wiring line 162 and electrode 178 were connected by using conductive paste 166 was measured. The stress generated when conductive paste 166 was used was approximately 1/4 of the stress generated when a general conductive paste was used. Therefore, by connecting wiring line 162 and electrode 178 by using conductive paste 166 having a low elastic modulus, that is, bump 168, electrical conduction between wiring line 162 and electrode 178 can be ensured.

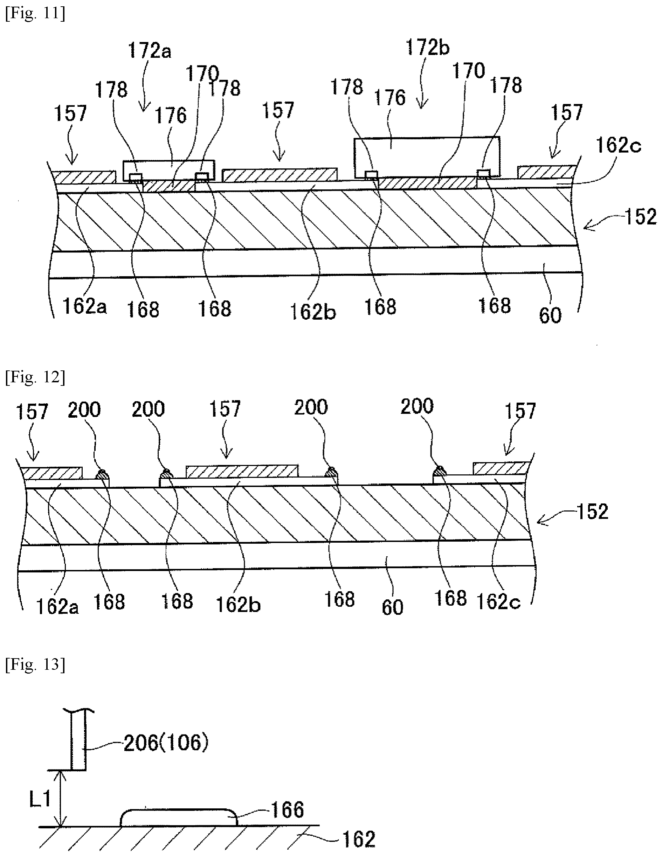

However, in the above-described method, electronic component 172 is mounted such that electrode 178 comes into contact with uncured conductive paste 166, and electronic component 172 is heated while being pressed by pressurizing plate 122, thereby electrically connecting electronic component 172 and wiring line 162 via bump 168. Therefore, there is a possibility that uncured conductive paste 166 is crushed during pressing, causing the thickness of bump 168 to become thin and making it difficult to appropriately ensure electrical conduction between wiring line 162 and electrode 178. In other words, since uncured conductive paste 166 is soft, when electronic component 172 is heated while being pressed by pressurizing plate 122, the thickness of bump 168 becomes thin as illustrated in Fig. 11. As described above, when the thickness of bump 168 becomes thin, the followability of bump 168 to the stress generated between wiring line 162 and electrode 178 decreases. Therefore, there is a possibility that electrical conduction between wiring line 162 and electrode 178 cannot be appropriately ensured.

Therefore, it is conceivable to reduce the pressing force of pressurizing plate 122 to secure the thickness of bump 168. In this way, by reducing the pressing force of pressurizing plate 122, the thickness of bump 168 can be secured, and the followability of bump 168 can be ensured. However, by reducing the pressing force of pressurizing plate 122, the metal particles included in conductive paste 166 may become less likely to come into close contact with each other during pressing, and the conductivity of bump 168 may decrease.

Therefore, it is conceivable to form bump 168 by curing conductive paste 166 before electronic component 172 is mounted. That is, as illustrated in Fig. 6, after conductive paste 166 is ejected onto wiring line 162, resin laminate 152 is heated by heater 66 incorporated into base plate 60. Here, the heating temperature is a temperature (for example, 80°C) at which conductive paste 166 is cured. As a result, conductive paste 166 is heated and cured via resin laminate 152 to form bump 168. Then, as illustrated in Fig. 7, thermosetting resin 170 is ejected between two wiring lines 162, and as illustrated in Fig. 8, electronic component 172 is mounted such that electrode 178 comes into contact with bump 168 and component body 176 comes into contact with thermosetting resin 170. Subsequently, as illustrated in Fig. 9, electronic component 172 is heated while being pressed by pressurizing plate 122. At this time, thermosetting resin 170 is cured by heating. However, conductive paste 166 is cured before electronic component 172 is mounted and becomes bump 168. Therefore, even when electronic component 172 is pressed, bump 168 is not excessively crushed, the thickness of bump 168 does not become excessively thin, and a predetermined thickness is secured. In this way, by curing conductive paste 166 before electronic component 172 is mounted, it is possible to secure the thickness of bump 168 and ensure the followability of bump 168. Therefore, curing conductive paste 166 before electronic component 172 is mounted is considered to be an effective method for forming a circuit board. However, even when electronic component 172 is pressed, bump 168 and electrode 178 may become less likely to come into close contact with each other. Therefore, it is desirable to further increase the adhesive force between bump 168 and electrode 178 and more appropriately ensure electrical conduction between bump 168 and electrode 178. When the adhesive force between bump 168 and electrode 178 is weak, thermosetting resin 170 may enter between bump 168 and electrode 178. In order to increase the adhesive force between bump 168 and electrode 178, it is conceivable to press the electronic component with a high pressure. However, when the electronic component is pressed with a high pressure, a problem such as breakage of the electronic component may occur.

As described above, curing conductive paste 166 before electronic component 172 is mounted is an effective method for forming a circuit board. However, by making improvements, the circuit board can be formed more suitably. Therefore, in circuit forming device 10, bump 168 is formed by heating conductive paste 166 before mounting electronic component 172, and electronic component 172 is mounted after the conductive paste is ejected onto bump 168. Specifically, as illustrated in Fig. 6, after conductive paste 166 is ejected onto wiring line 162, resin laminate 152 is heated by heater 66 incorporated into base plate 60. Here, the heating temperature is a temperature (for example, 80°C) at which conductive paste 166 is cured. As a result, conductive paste 166 is heated and cured via resin laminate 152 to form bump 168.

Next, as illustrated in Fig. 12, conductive paste 200 is ejected onto bump 168 by dispenser 106. At this time, dispenser 106 ejects conductive paste 200 such that the ejection amount of conductive paste 200 is smaller than the ejection amount of conductive paste 166. Dispenser 106 ejects conductive paste 200 at the same ejection amount per unit time as the ejection amount per unit time when conductive paste 166 is ejected. At this time, regarding the moving speed of stage 52, that is, the relative speed between stage 52 and dispenser 106, the moving speed of stage 52 when dispenser 106 ejects conductive paste 200 is set higher than the moving speed of stage 52 when dispenser 106 ejects conductive paste 166. Accordingly, the ejection time when dispenser 106 ejects conductive paste 200 is shorter than the ejection time when dispenser 106 ejects conductive paste 166, and the ejection amount of conductive paste 200 is smaller than the ejection amount of conductive paste 166. That is, the ejection amount of conductive paste 200 is made smaller than the ejection amount of conductive paste 166 by changing the moving speed of stage 52 without changing the ejection amount per unit time. Accordingly, the ejection amount of conductive paste 200 can be made smaller than the ejection amount of conductive paste 166 without changing the ejection amount per unit time. Further, by making the ejection amount of conductive paste 200 smaller than the ejection amount of conductive paste 166, conductive paste 200 can be ejected onto bump 168 without protruding from bump 168.

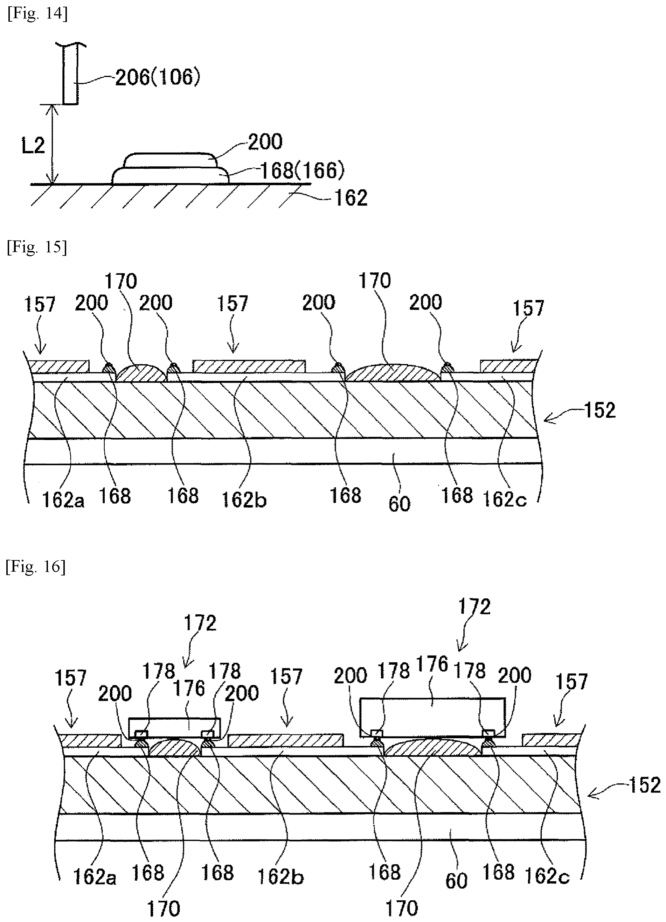

The ejection height when conductive paste 200 is ejected is set higher than the ejection height when conductive paste 166 is ejected. Specifically, as illustrated in Fig. 13, the ejection height of dispenser 106 when conductive paste 166 is ejected, that is, the distance between the lower end of ejection nozzle 206 of dispenser 106 and the upper surface of wiring line 162 is set to L1. Meanwhile, as illustrated in Fig. 14, the ejection height of dispenser 106 when conductive paste 166 is ejected is set to L2. Ejection height L2 for conductive paste 200 is higher than ejection height L1 for conductive paste 166. As described above, by setting ejection height L2 for conductive paste 200 to be higher than ejection height L1 for conductive paste 166, it is possible to prevent ejection nozzle 206 of dispenser 106 from coming into contact with bump 168 when conductive paste 200 is ejected.

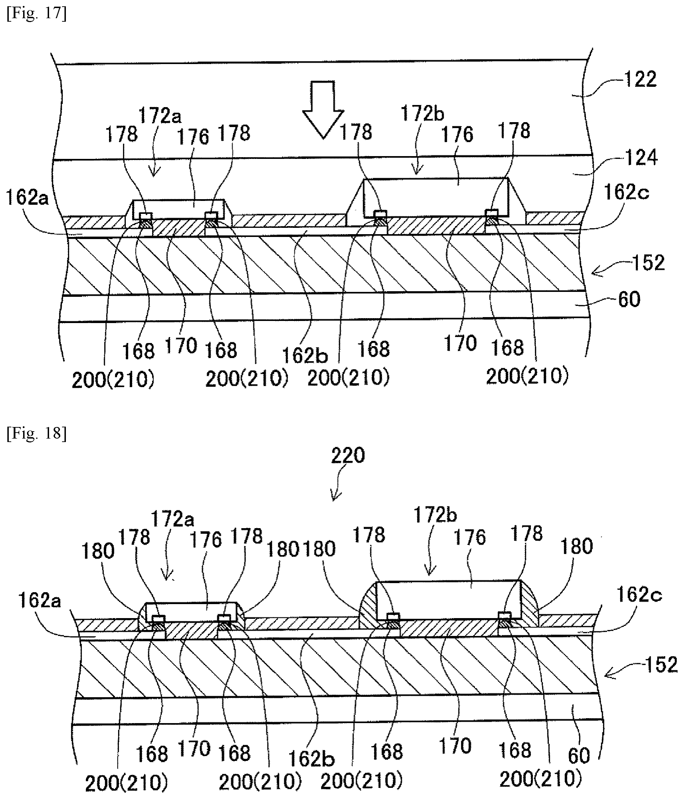

When conductive paste 200 is ejected onto bump 168 in this manner, thermosetting resin 170 is ejected between two wiring lines 162 as illustrated in Fig. 15. Then, as illustrated in Fig. 16, electronic component 172 is mounted such that electrode 178 comes into contact with conductive paste 200 and component body 176 comes into contact with thermosetting resin 170. Subsequently, as illustrated in Fig. 17, electronic component 172 is pressed by pressurizing plate 122 via rubber plate 124. At this time, resin laminate 152 is heated by heater 66 incorporated into base plate 60. As a result, conductive paste 200 and thermosetting resin 170 are heated and cured via resin laminate 152. Here, the heating temperature is a temperature (for example, 80°C) at which conductive paste 200 and thermosetting resin 170 are cured. At this time, since conductive paste 200 ejected onto bump 168 is uncured, conductive paste 200 and electrode 178 of electronic component 172 come into close contact with each other when electronic component 172 is pressed. Then, conductive paste 200 is cured by heating of heater 66, thereby forming bump 210 in close contact with electrode 178. Since bump 210 is formed when uncured conductive paste 200 is pressed, the thickness of bump 210 becomes thin. However, bump 168 located below bump 210 is less likely to be crushed even when electronic component 172 is pressed. Therefore, in bump 168 located below bump 210, a predetermined thickness is secured. That is, in first-stage bump 168 located below bump 210, a predetermined thickness is secured, and in second-stage bump 210 located above bump 168, an adhesive force with electrode 178 is ensured. As described above, by adopting the two-stage structure of bumps 168 and 210, first-stage bump 168 is deformed in accordance with the stress generated between wiring line 162 and electrode 178, and second-stage bump 210 comes into close contact with electrode 178. Accordingly, it is possible to appropriately ensure electrical conduction between electrode 178 and the two-stage structure of bumps 168 and 210.

After conductive paste 200 and thermosetting resin 170 are cured by being heated while being pressed, thermosetting resin 180 is ejected to cover the side surface of component body 176 of electronic component 172, and resin laminate 152 is heated by heater 66, as illustrated in Fig. 18. As a result, thermosetting resin 180 is cured, and electronic component 172 is fixed by thermosetting resins 170 and 180, thereby forming circuit board 220.

As illustrated in Fig. 2, controller 140 of control device 28 includes wiring forming section 230, first application section 232, first curing section 234, second application section 236, mounting section 238, and second curing section 240. Wiring forming section 230 is a functional section that forms wiring line 162 on resin laminate 152. First application section 232 is a functional section for applying conductive paste 166 onto wiring line 162. First curing section 234 is a functional section for curing conductive paste 166. Second application section 236 is a functional section for applying conductive paste 200 onto bump 168. Mounting section 238 is a functional section for mounting electronic component 172 such that electrode 178 comes into contact with conductive paste 200. Second curing section 240 is a functional section for curing conductive paste 200.

In the above example, circuit forming device 10 is an example of an electrical circuit forming device. First shaping unit 22 is an example of a wiring forming device. Mounting unit 27 is an example of a mounting device. Heater 66 is an example of a curing device. Dispenser 106 is an example of an application device. Resin laminate 152 is an example of a resin layer. Wiring line 162 is an example of a metal wiring line. Conductive paste 166 is an example of a conductive fluid. Electronic component 172 is an example of an electronic component. Electrode 178 is an example of an electrode. Conductive paste 200 is an example of a conductive fluid. In addition, a step executed by wiring forming section 230 is an example of a wiring forming step. A step executed by first application section 232 is an example of a first application step. A step executed by first curing section 234 is an example of a first curing step. A step executed by second application section 236 is an example of a second application step. A step executed by mounting section 238 is an example of a mounting step. A step executed by second curing section 240 is an example of a second curing step.

The present invention is not limited to the above example and can be performed in various aspects in which various modifications and improvements are made based on the knowledge of those skilled in the art. For example, in the above example, thermosetting resin 170 is ejected onto resin laminate 152 before electronic component 172 is mounted, and thermosetting resin 180 is ejected onto resin laminate 152 after electronic component 172 is mounted. Alternatively, thermosetting resin 170 and thermosetting resin 180 may be ejected onto resin laminate 152 after electronic component 172 is mounted. That is, after electronic component 172 is mounted, thermosetting resin 170 may be ejected between electronic component 172 and resin laminate 152, and thermosetting resin 180 may be ejected so as to surround electronic component 172. After thermosetting resin 170 and thermosetting resin 180 are ejected, electronic component 172 is heated while being compressed by pressurizing plate 122, so that thermosetting resin 170 and thermosetting resin 180 are cured.

In addition, in the above example, electronic component 172 is mounted such that component body 176 comes into contact with uncured thermosetting resin 170 after thermosetting resin 170 is ejected. Alternatively, after thermosetting resin 170 is ejected, thermosetting resin 170 may be semi-cured by heater 66, and electronic component 172 may be mounted such that component body 176 comes into contact with semi-cured thermosetting resin 170. At this time, after electronic component 172 is mounted, electronic component 172 is heated while being compressed by pressurizing plate 122, so that thermosetting resin 170 is completely cured. The heating conditions for semi-curing the thermosetting resin are conditions that do not satisfy the heating conditions for completely curing the thermosetting resin. For example, when the thermosetting resin is completely cured by heating at 80°C for 1 hour, the thermosetting resin may be semi-cured by heating at 60°C for 30 minutes.

In the above example, the ejection amount of conductive paste 200 is made smaller than the ejection amount of conductive paste 166 by changing the moving speed of stage 52 without changing the ejection amount of dispenser 106 per unit time. Alternatively, the ejection amount of conductive paste 200 may be made smaller than the ejection amount of conductive paste 166 by changing the ejection amount of dispenser 106 per unit time without changing the moving speed of stage 52. The ejection amount of conductive paste 200 may be made smaller than the ejection amount of conductive paste 166 by changing at least one of the moving speed of stage 52 and the ejection amount of dispenser 106 per unit time.

In the above example, after conductive paste 166 is completely cured to form bump 168, conductive paste 200 is ejected onto bump 168. Alternatively, after conductive paste 166 is semi-cured, conductive paste 200 may be ejected onto semi-cured conductive paste 166. After electronic component 172 is mounted such that electrode 178 comes into contact with conductive paste 200, conductive paste 166 and conductive paste 200 may be completely cured by heating electronic component 172 while being compressed by pressurizing plate 122. The heating conditions for semi-curing the conductive paste are conditions that do not satisfy the heating conditions for completely curing the conductive paste. For example, when the conductive paste is completely cured by heating at 80°C for 1 hour, the conductive paste may be semi-cured by heating at 60°C for 30 minutes.

In the above example, the conductive paste or thermosetting resin is heated at 80°C when being cured. However, the conductive paste or thermosetting resin may be cured by heating the conductive paste or thermosetting resin at a temperature of 80°C or higher. However, in consideration of thermal expansion or the like, the heating is preferably performed at a lower limit temperature at which the conductive paste or the thermosetting resin is cured.

Further, in the above example, conductive paste 166 is employed as the conductive fluid for electrically connecting wiring line 162 and electrode 178 of electronic component 172, but various fluids can be employed as long as the fluid exhibits conductivity.

Additionally, in the above embodiment, the thermosetting resin is employed as the curable resin for fixing electronic component 172, but an ultraviolet curable resin, a two-liquid mixed curable resin, a thermoplastic resin, and the like can be formed. Further, in the above example, the ultraviolet curable resin is employed as the resin for forming resin laminate 152, and the thermosetting resin is employed as the resin for fixing electronic component 172. That is, the resin for forming resin laminate 152 and the resin for fixing electronic component 172 are different curable resins, but the resin for forming resin laminate 152 and the resin for fixing electronic component 172 may be the same curable resin.

In addition, in the above example, the conductive paste is ejected by dispenser 106, but the conductive paste may be transferred by a transfer device or the like. Alternatively, the conductive paste may be printed through screen printing.

The present description discloses a technical idea in which "the electrical circuit forming method according to Claim 1" in Claim 3 as originally filed is changed to "the electrical circuit forming method according to Claim 1 or 2", and a technical idea in which "the electrical circuit forming method according to Claim 1" in Claim 4 originally filed is changed to "the electrical circuit forming method according to any one of Claims 1 to 3".

Reference Signs List

10: circuit forming device (electrical circuit forming device), 22: first shaping unit (wiring forming device), 27: mounting unit (mounting device), 66: heater (curing device), 106: dispenser (application device), 152: resin laminate (resin layer), 162: wiring line (metal wiring line), 166: conductive paste (conductive fluid), 172: electronic component, 178: electrode, 200: conductive paste (conductive fluid), 230: wiring forming section (wiring forming step), 232: first application section (first application step), 234: first curing section (first curing step), 236: second application section (second application step), 238: mounting section (mounting step), 240: second curing section (second curing step)

**Claims**

1.  An electrical circuit forming method comprising:

    a wiring forming step of forming a metal wiring line on a resin layer;
    a first application step of applying a conductive fluid to a planned mounting position of an electrode of an electronic component on the metal wiring line;
    a first curing step of curing the conductive fluid applied in the first application step;
    a second application step of applying the conductive fluid onto the conductive fluid cured in the first curing step;
    a mounting step of mounting the electronic component such that the electrode comes into contact with the conductive fluid applied in the second application step; and
    a second curing step of curing the conductive fluid applied in the second application step after the electronic component is mounted in the mounting step.

2.  The electrical circuit forming method according to Claim 1, wherein an application amount of the conductive fluid applied in the second application step is smaller than an application amount of the conductive fluid applied in the first application step.

3.  The electrical circuit forming method according to Claim 1,

    wherein the first application step and the second application step are steps of applying the conductive fluid by ejecting the conductive fluid, and an ejection height for the conductive fluid in the second application step is higher than an ejection height for the conductive fluid in the first application step.

4.  The electrical circuit forming method according to Claim 1, wherein the second curing step is the step of curing the conductive fluid while pressing the electronic component toward the resin layer.

5.  The electrical circuit forming method according to any one of Claims 1 to 4, wherein the conductive fluid having an elastic modulus of 0.2 GPa or less when being cured is applied in the first application step and the second application step.

6. An electrical circuit forming device comprising:

a wiring forming device configured to form a metal wiring line;
an application device configured to apply a conductive fluid;
a curing device configured to cure the conductive fluid;
a mounting device configured to mount an electronic component; and
a control device,
wherein the control device is configured to execute:

a wiring forming process of forming the metal wiring line on a resin layer using the wiring forming device;
a first application process of applying the conductive fluid onto a planned mounting position of an electrode of an electronic component on the metal wiring line using the application device;
a first curing process of curing the conductive fluid applied in the first application process using the curing device;
a second application process of applying a conductive fluid onto the conductive fluid cured in the first curing process using the application device;
a mounting process of mounting the electronic component such that the electrode comes into contact with the conductive fluid applied in the second application process using the mounting device; and
a second curing process of curing the conductive fluid applied in the second application process using the curing device after the electronic component is mounted in the mounting process.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

172a
178 170 178
157 176 172b 157 178 176 170 178 157 162c
152
162a 168 168 162b 168 168 60

[Fig. 12]

157 200 200 157 200 200 157
152
162a 168 168 162b 168 60 168 162c

[Fig. 13]

206(106)
L1
166
162

[Fig. 14]

L2

206(106)
200
168(166)
162

[Fig. 15]

157  200  170  200  157  200  170  200  157

152

162a  168  168  162b  168  60  168  162c

[Fig. 16]

172

178  178
157  200  176  200  157  200  178  176  178  200  157

172

152

162a  168  168  162b  168  60  168  162c
170  170

[Fig. 17]

[Fig. 18]

## INTERNATIONAL SEARCH REPORT

| | International application No. |
|---|---|
| | **PCT/JP2023/009100** |

| A. CLASSIFICATION OF SUBJECT MATTER |
|---|
| **H05K 3/32**(2006.01)i<br>FI: H05K3/32 B |
| According to International Patent Classification (IPC) or to both national classification and IPC |

| B. FIELDS SEARCHED |
|---|
| Minimum documentation searched (classification system followed by classification symbols)<br>H05K 3/30 - 3/34, H05K 13/00 - 13/08 |
| Documentation searched other than minimum documentation to the extent that such documents are included in the fields searched<br>Published examined utility model applications of Japan 1922-1996<br>Published unexamined utility model applications of Japan 1971-2023<br>Registered utility model specifications of Japan 1996-2023<br>Published registered utility model applications of Japan 1994-2023 |
| Electronic data base consulted during the international search (name of data base and, where practicable, search terms used) |

| C. DOCUMENTS CONSIDERED TO BE RELEVANT |
|---|

| Category* | Citation of document, with indication, where appropriate, of the relevant passages | Relevant to claim No. |
|---|---|---|
| Y | WO 2020/079744 A1 (FUJI CORPORATION) 23 April 2020 (2020-04-23)<br>paragraphs [0008]-[0049], fig. 1-14 | 1-6 |
| Y | WO 2022/195800 A1 (FUJI CORPORATION) 22 September 2022 (2022-09-22)<br>paragraphs [0009]-[0062], fig. 1-9 | 1-6 |

| ☐ Further documents are listed in the continuation of Box C. | ✓ See patent family annex. |
|---|---|

| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search | Date of mailing of the international search report |
|---|---|
| **18 May 2023** | **30 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/009100**

| Patent document cited in search report | | | Publication date (day/month/year) | Patent family member(s) | | | Publication date (day/month/year) |
|---|---|---|---|---|---|---|---|
| WO | 2020/079744 | A1 | 23 April 2020 | CN | 112868273 | A | |
| | | | | US | 2022/0039263 | A1 | |
| | | | | paragraphs [0021]-[0065], fig. 1-14 | | | |
| WO | 2022/195800 | A1 | 22 September 2022 | (Family: none) | | | |

Form PCT/ISA/210 (patent family annex) (January 2015)

## REFERENCES CITED IN THE DESCRIPTION

**Patent documents cited in the description**

- WO 2022113186 A